(19) **Europäisches Patentamt / European Patent Office / Office européen des brevets**

(11) **EP 2 256 922 B1**

(12) **FASCICULE DE BREVET EUROPEEN**

(45) Date de publication et mention
de la délivrance du brevet:
**22.02.2012   Bulletin 2012/08**

(51) Int Cl.:
***H03B 5/30*** (2006.01)

(21) Numéro de dépôt: **10154740.4**

(22) Date de dépôt: **25.02.2010**

(54) **Dispositif résonant à caractéristiques améliorées**

Netzwerk aus gekoppelten Resonatoren, Bandpassfilter und Oszillator

Resonant device with improved characteristics

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **27.02.2009   FR 0900904**

(43) Date de publication de la demande:
**01.12.2010   Bulletin 2010/48**

(73) Titulaire: **Commissariat à l'Énergie Atomique et aux Énergies Alternatives**
**75015 Paris (FR)**

(72) Inventeurs:
• **Duraffourg, Laurent**
**38500 Voiron (FR)**
• **Andreucci, Philippe**
**38430 Moirans (FR)**
• **Colinet, Eric**
**38240 Meylan (FR)**
• **Hentz, Sébastien**
**38000 Grenoble (FR)**
• **Ollier, Eric**
**38100 Grenoble (FR)**

(74) Mandataire: **de Jong, Jean Jacques**
**Cabinet Hecké**
**10, rue d'Arménie**
**Europole**
**BP 1537**
**38025 Grenoble Cedex 1 (FR)**

(56) Documents cités:
**FR-A- 2 336 788      FR-A- 2 533 777**
**US-A- 2 595 652      US-A- 3 378 789**

## Description

### Domaine technique de l'invention

L'invention est relative à un dispositif résonant.

### État de la technique

Afin de pourvoir continuer la course à la miniaturisation, les circuits microélectroniques doivent intégrer de nouvelles fonctions tout en minimisant la surface des circuits. Un des principaux domaines d'étude est l'intégration de dispositifs résonants à l'intérieur des puces. En effet, dans de nombreux domaines, tels que les capteurs chimiques en phase gazeuse, les capteurs de force moléculaire ou encore les spectromètres de masse, il est intéressant que le circuit intégré comporte au moins un oscillateur. Les concepteurs travaillent à remplacer l'oscillateur qui est un composant discret supplémentaire par un oscillateur intégré. En intégrant cet oscillateur, on peut alors espérer, en plus du gain en surface ou en volute du dispositif, un gain en énergie consommée et une amélioration des performances.

De nombreuses publications traitent de résonateurs électromécaniques de taille micrométrique ou nanométrique, c'est-à-dire des résonateurs ayant des dimensions compatibles avec celles des circuits intégrés. Un article de Feng et al. « A self-sustaining ultrahigh-frequency nanoelectromechanical oscillator » nature nanotechnology, vol. 3, juin 2008, décrit un oscillateur qui comporte un résonateur électromécanique de taille nanométrique associé à un circuit de contre-réaction complexe.

Le document FR 2 533 777 décrit un oscillateur hyperfréquence de puissance constitué par une pluralité d'oscillateurs élémentaires. Les d'oscillateurs élémentaires sont couplés en parallèle et chaque oscillateur élémentaire comporte un transistor à effet de champ, monté en drain commun. La source du transistor est reliée à la charge utile commune par l'intermédiaire d'un tronçon de ligne permettant d'effectuer l'adaptation d'impédance. Les lignes microbandes de grille des oscillateurs élémentaires sont reliées entre elles.

Cependant, les performances de ce type d'oscillateur sont nettement insuffisantes, il est alors nécessaire de trouver une nouvelle architecture qui soit en mesure d'améliorer les caractéristiques de l'oscillateur.

### Objet de l'Invention

L'objet de l'invention consiste à réaliser un dispositif résonant qui soit facile à mettre en oeuvre et qui présente des performances accrues par rapport aux oscillateurs connus.

Le dispositif selon l'invention est caractérisé par les revendications annexées et plus particulièrement par le fait qu'il comporte une pluralité d'oscillateurs synchronisés, chaque oscillateur comportant un résonateur électromécanique comportant des moyens de détection fournissant des signaux de détection, représentatifs de l'oscillation du résonateur, à une boucle de réaction connectée à une entrée d'excitation du résonateur, les signaux de détection commandant la conductivité de ladite boucle de réaction de l'oscillateur, les entrées d'excitation de tous les résonateurs étant connectée à un point commun, constituant la sortie du dispositif résonant, une charge capacitive étant connectée entre ledit point commun et une tension de référence.

### Description sommaire des dessins

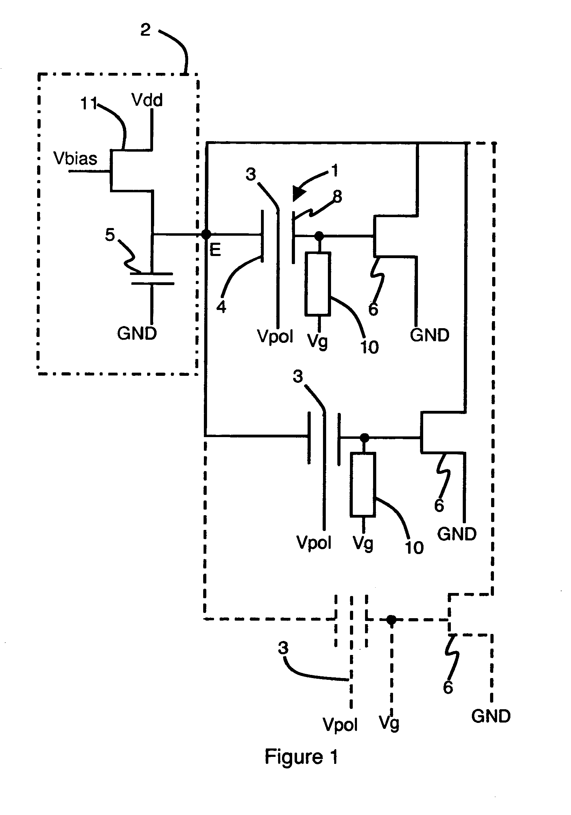

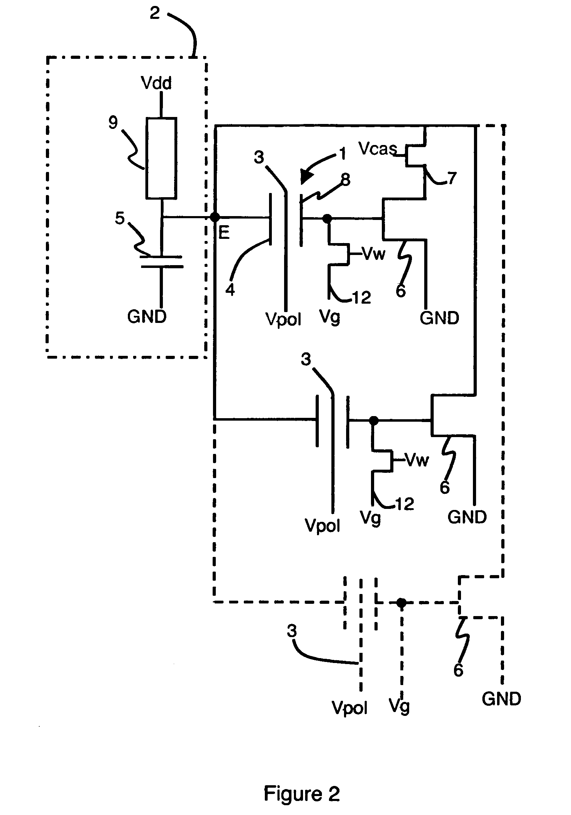

D'autres avantages et caractéristiques ressortiront plus clairement de la description qui va suivre de modes particuliers de réalisation de l'invention donnés à titre d'exemples non limitatifs et représentés aux dessins annexés, dans lesquels les figures 1 et 2 représentent, de manière schématique, deux modes de réalisation particuliers d'un dispositif selon l'invention.

### Description de modes de réalisation préférentiels de l'invention

Comme illustré à la figure 1, le dispositif résonant comporte une pluralité d'oscillateurs, au moins deux oscillateurs, qui sont synchronisés. Chaque oscillateur comporte un résonateur éléctromécanique 1 et son circuit d'oscillation associé qui comporte un élément de polarisation 2 capacitif. L'élément de polarisation 2 est commun à l'ensemble des oscillateurs et comporte au moins une charge 5 capacitive.

Les oscillateurs formant le dispositif résonant sont simplement reliés électriquement entre eux. Chaque oscillateur est dimensionné de manière à présenter la même fréquence de résonance. Les différences qui existent entre les fréquences de résonance proviennent des incertitudes dans le procédé de réalisation et ces différences entre les fréquences de résonance peuvent être compensées en ajustant le gain de leur boucle de réaction. Cet ajustement de chaque gain n'est pas une condition nécessaire mais un mode de réalisation avantageux.

Le résonateur 1 est du type électromécanique avantageusement de taille micrométrique ou nanométrique Le résonateur comporte des moyens d'excitation et des moyens de détection de l'oscillation. Le résonateur 1 comporte une entrée d'excitation E qui agit sur les moyens d'excitation.

Le résonateur élèctromécanique, comporte un élément mobile 3 et au moins un élément fixe 4. L'élément mobile 3 peut osciller par rapport à l'élément fixe 4. L'élément fixe 4 représente au moins les moyens d'excitation de l'élément mobile 3 du résonateur 1. Ainsi, on considère que les moyens d'excitation font partie intégrante du résonateur 1. De ce fait, dans le résonateur 1 l'entrée d'excitation E, également appelée borne d'excitation, commande la force d'excitation émise par l'élément fixe 4, également appelée électrode d'excitation.

Les moyens d'excitation sont avantageusement de type capacitif ou de type thermoélastique, mais ils peuvent également être d'un autre type adapté à l'actionnement de l'élément mobile 3.

D'une manière générale, l'oscillateur comporte des moyens de détection de l'oscillation à l'intérieur du résonateur, soit d'un signal électrique, soit d'un mouvement mécanique de l'élément mobile. Plus particulièrement, l'oscillateur comporte des moyens de détection du mouvement de l'élément mobile 3 par rapport à l'élément fixe 4. Les moyens de détections convertissent le mouvement de l'élément mobile 3 en un signal électrique qui est alors un signal représentatif de la position de l'élément mobile 3 par rapport à l'élément fixe 4. Les moyens de détections transmettent un signal représentatif de l'oscillation du résonateur 1.

Comme illustré à la figure 1, dans un mode de réalisation particulier, il est possible d'utiliser un résonateur 1 qui possède un élément fixe additionnel 8. Cet élément fixe additionnel 8 peut être associé à une borne d'excitation supplémentaire. L'élément fixe additionnel peut également être une électrode de détection permettant de mieux découpler les signaux d'excitation et de détection. Une tension de polarisation Vg est alors appliquée sur l'élément fixe additionnel 8 afin de mieux contrôler les caractéristiques du résonateur 1. La tension de polarisation Vg permet de contrôler le point de fonctionnement du transistor L'électrode d'excitation supplémentaire n'est utilisable que pour une excitation de type capacitive. L'élément fixe peut comporter les moyens de détection et alors être associé à la borne de détection D.

Dans l'exemple de la figure 1, la détection est de type capacitive, le résonateur peut donc être assimilé à une capacité variable. Cette capacité variable est obtenue au moyen de l'utilisation des électrodes fixes 4 et 8 pour permettre l'excitation et la détection dans le résonateur. Si le résonateur ne comporte qu'une seule électrode fixe 4, la détection du mouvement est alors réalisée au moyen de l'élément mobile 3.

Les moyens de détections sont avantageusement de type capacitif ou de type piézorésistif, mais ils peuvent également être d'un autre type adapté à la mesure de la position de l'élément mobile 3.

Afin de former un oscillateur, le signal émis par les moyens de détection, qui peut être représentatif du mouvement de l'élément mobile 3 du résonateur 1, doit être transformé, en général amplifié et déphasé, de manière à ce que les conditions d'oscillations soient remplies. Le signal représentatif transformé est alors réinjecté dans le résonateur 1 par l'intermédiaire des moyens d'excitation, c'est-à-dire par sa borne d'excitation E.

La transformation du signal est réalisée dans une boucle de réaction qui connecte les moyens de détection à la borne d'excitation E et par le fait que l'élément de polarisation 2 comporte une charge 5 capacitive, ici un condensateur. Le signal en courant, issu du résonateur 1 par les moyens de détection, est amplifié en tension et déphasé de 90° ou $\pi/2$ au moyen de l'élément de polarisation 2 capacitif. Le condensateur 5 peut être constitué, avantageusement, par une capacité parasite qui provient de pistes d'interconnexion.

La boucle de réaction peut être réalisée en technologie CMOS, c'est-à-dire au moyen de transistors à effet de champ de type P et N, ou en technologie bipolaire, ou en technologie BiCMOS qui comporte simultanément les deux technologies précédentes. La boucle de réaction peut également être formée par un circuit électrique passif de type RLC.

Ainsi, les moyens de détection fournissent des signaux de détection, représentatifs de l'oscillation du résonateur à la boucle de réaction qui est connectée à l'entrée d'excitation E du résonateur 1.

Les bornes d'excitation E de tous les résonateurs sont connectées à un même point commun, un noeud électrique, qui constitue la borne de sortie du dispositif résonant, ce qui permet d'obtenir une synchronisation des oscillateurs qui se mettent tous à osciller en phase sur une fréquence commune. Tous les oscillateurs sont connectés à une même charge 5 capacitive permettant une synchronisation des oscillateurs sans avoir à utiliser un couplage mécanique et/ou électromagnétique. Ainsi, il n'y a pas de couplage mécanique, ni de couplage électrostatique entre les différents oscillateurs. Comme toutes les bornes d'excitation E des résonateurs sont connectées à un même point commun, il est alors possible de considérer que ce point commun représente une borne d'excitation commune à tous les résonateurs bien que les bornes soient physiquement distinctes.

Le courant électrique de chaque boucle de réaction est appliqué sur la borne d'excitation E, c'est-à-dire que la somme des courants est appliquée sur l'élément de polarisation 2 capacitif qui applique alors une tension représentative de cette somme sur l'ensemble des résonateurs.

Ainsi, chaque résonateur possède son propre étage de gain formé par sa propre boucle de réaction. La fréquence d'oscillation générée par le dispositif résonant correspond à la fréquence commune qui respecte la condition d'oscillation pour chaque oscillateur. Ici, toute modification de l'état de l'un des oscillateurs induit une modification des conditions d'oscillation de tous les oscillateurs, car la borne d'excitation est commune à tous les oscillateurs. L'ajustement de la fréquence de résonance peut donc être réalisée aisément. Le fonctionnement est donc différent par rapport à un dispositif qui comporte un réseau de plusieurs résonateurs qui sont rebouclés entre eux et pour lequel il n'y a qu'une seule condition d'oscillation possible.

De cette manière, le dispositif résonant a un fonctionnement robuste concernant une éventuelle dispersion des fréquences entre les oscillateurs. En effet, il suffit juste de modifier le gain des différentes boucles de réaction pour atteindre la synchronisation. Cette modification est obtenue en modulant les tensions de polarisation Vg des différents oscillateurs.

L'utilisation d'un dispositif comportant une pluralité d'oscillateurs fonctionnant à la même fréquence permet de réduire le bruit de phase, typiquement en racine du nombre d'oscillateurs, ceci est d'autant plus réaliste que les bruits inhérents à chaque oscillateur sont totalement non corrélés et que les fréquences de résonance des résonateurs ne présentent pas de dispersion.

De plus, l'amplitude du signal global de sortie, qui est délivrée sur la borne d'excitation E, est la somme des amplitudes de chaque oscillateur (si tous les oscillateurs ont exactement la même fréquence d'oscillation). Le gain nécessaire pour la boucle de réaction est donc inversement proportionnel au nombre d'oscillateurs qui est utilisé dans le dispositif résonant. Cette approche permet donc de simplifier l'architecture de la boucle de réaction qui peut alors être réduite à un premier transistor ou à des premier et second transistors connectés en série.

Les conditions d'oscillation sont définies classiquement par les conditions de Barkhausen. Il en résulte que le produit de la fonction de transfert H du résonateur par la fonction de transfert G du circuit électronique qui lui est associé doit avoir un gain au moins égale à 1 et la différence de phase entre les signaux provenant du résonateur 1 et de la boucle de réaction doit être égale à 2.k. π avec k entier, à la fréquence de résonance.

La fonction de transfert H du résonateur 1 tient compte des caractéristiques mécaniques du résonateur 1 ainsi que de la fonction de transfert des moyens d'excitation. La fonction de transfert H du résonateur 1 est fonction de la masse, de la raideur, du coefficient d'amortissement, c'est-à-dire des paramètres géométriques du résonateur et de ses conditions d'encastrement.

La fonction de transfert du circuit électronique associé correspond à la fonction de transfert de la boucle de réaction et des moyens de détection. Si les moyens de détection et d'excitation sont considérés comme des gains K, les conditions de Barkhausen peuvent être redéfinies de la manière suivante :

- il suffit que la boucle de réaction réalise un déphasage égale à π/2 entre le signal qui rentre dans la boucle de réaction et le signal qui sort de la boucle de réaction et que

- le module du circuit associé soit égale à la formule

$$\|G(j\omega_0)\| = \frac{\omega_0 \frac{\omega_0^2}{m_{eff}\omega_0^2}}{K_{détect}K_{excit}Q}$$ dans laquelle :

$m_{eff}$ est la masse effective du résonateur,
$\omega_0$ est la fréquence de résonance,
$K_{détect}$ est le gain des moyens de détection,
$K_{excit}$ est le gain des moyens d'excitation,
Q est le facteur de qualité.

Il en résulte que pour former un oscillateur, la boucle de réaction doit comporter des dispositifs qui sont en mesure de réaliser le déphasage ci-dessus et d'assurer un gain suffisant pour obtenir des oscillations auto-entretenues.

La boucle de réaction est connectée entre une tension de référence GND et la borne d'excitation E. Les signaux représentatifs de l'oscillation du résonateur sont appliqués sur la boucle de réaction et modulent sa conductivité. La boucle de réaction peut être réalisée par tout circuit connu permettant l'amplification du signal d'entrée.

Dans le cas d'un résonateur de type électromécanique, de taille nanométrique ou micrométrique, la boucle de régulation peut être constituée par un premier transistor 6 ou par un premier 6 et un second 7 transistors montés en série (figure 2) ou comporter au plus ces deux transistors montés en série. Le second transistor 7 est un transistor d'amplification qui permet d'amplifier la valeur du courant qui est délivré en sortie du premier transistor 6. Comme illustré à la figure 2, l'électrode de commande du second transistor 7 est reliée à un potentiel extérieur Vcas.

Dans l'oscillateur, le premier transistor 6 est connecté entre une tension de référence GND et la borne d'excitation E. Un second transistor 7 peut également être connecté en série avec le premier transistor 6 entre la tension de référence GND et la borne d'excitation E. Les premier 6 et second 7 transistors peuvent être indépendamment de type à effet de champ ou bipolaire. Les premier 6 et second 7 transistors peuvent ainsi être de même type ou de types différents.

Si le premier transistor 6 est de type à effet de champ, une première électrode de source/drain du premier transistor 6 est connectée à la tension de référence GND. Une seconde électrode de source/drain est connectée à la borne de d'excitation E directement ou par l'intermédiaire d'un second transistor 7.

Dans le cas d'une excitation et d'une détection par des moyens de type capacitif, il est avantageux d'utiliser deux électrodes distinctes, c'est-à-dire deux éléments fixes 4 et 8, disposées de part et d'autre du résonateur 1. Une 4 des électrodes réalise l'excitation de l'élément mobile 3 et l'autre électrode 8 réalise la détection du mouvement de l'élément mobile 3. De cette manière, les couplages électrostatiques sont fortement réduits entre les deux électrodes.

La conductivité du premier transistor 6 est commandée par les signaux de détection émis par les moyens de détection. Ainsi, selon la position de l'élément mobile 3 par rapport à l'élément fixe 4, l'amplitude du signal de détection évolue et fait varier la valeur du courant électrique circulant entre les deux bornes du premier transistor 6.

Le résonateur 1 peut être à mouvement dans le plan ou à mouvement hors du plan. Le résonateur 1 peut être, par exemple, un résonateur de type poutre encastrée-libre (encastrement simple) ou encastrée-encastrée (encastrement double) ou de tout autre type connu, par exemple de type plaque, disque, nanofil.

L'utilisation d'une boucle de réaction ne comportant qu'au plus deux transistors 6 et 7 est particulièrement avantageuse car elle autorise une intégration de la boucle au plus près du résonateur 1 ce qui permet de fortement réduire la surface occupée par l'oscillateur. De plus, les capacités parasites sont également fortement réduite, ces capacités sont responsables d'une perte du signal utile et de l'apparition d'un bruit de fond empêchant toute oscillation possible. La boucle de réaction comporte au plus deux transistors mais elle peut comporter également, dans des cas particuliers, des éléments passifs tels que, par exemple, des résistances ou des condensateurs.

Le premier transistor 6 étant situé au plus près du résonateur 1, l'influence des capacités parasites est négligeable au regard de la capacité d'entrée du transistor 6 et de la capacité statique du résonateur 1.

La polarisation du premier transistor 6 est réalisée au moyen de l'élément de polarisation 2 qui est connecté avec le premier 6 ou le second 7 transistor à la borne d'excitation E.

Dans un mode de réalisation particulier de l'oscillateur, l'excitation et la détection sont de type capacitif. Comme illustré à la figure 1, la boucle de réaction est constituée par le premier transistor 6 dont l'électrode de commande, l'électrode de grille ou de base, est connectée aux moyens de détection. De cette manière, les moyens de détection modulent la conductivité du premier transistor 6. Le courant délivré par le premier transistor 6 peut être amplifié ou non pour commander la force d'actionnement produite par les moyens d'excitation.

Dans un autre mode de réalisation particulier, le résonateur 1, les moyens d'excitation et les moyens de détection peuvent être constitués par un transistor à grille suspendue. Ce mode de réalisation a notamment été décrit dans un article de Colinet et al. « Measurement of Nano-Displacement Based on In-Plane Suspended-Gate MOSFET Detection Compatible with a Front-End CMOS Process » ISSCC 2008, 18.2 et dans le document WO 2007135064. Dans ce mode de réalisation, le premier transistor 6 est un transistor à effet de champ et sa grille est formée, au moins en partie par l'élément mobile 3 du résonateur 1. Il en résulte que la valeur de la capacité MOS entre le canal et l'élément mobile 3 varie en fonction de la position de l'élément mobile 3 par rapport au canal. Le canal du premier transistor 6 joue alors le rôle de moyen de détection, c'est-à-dire d'élément fixe 4, qui commande la conductivité du premier transistor 6.

Comme illustré à la figure 1, pour ce type d'oscillateur, l'élément de polarisation 2 peut comporter un condensateur 5 connecté en série avec une résistance de polarisation 9 aux bornes d'une alimentation. Dans ce cas de figure, la borne commune à la résistance 9 et au condensateur 5 est connectée à la borne d'excitation E.

Dans ces deux modes de réalisation précédents, l'élément mobile 3 peut être polarisé au moyen d'une tension de polarisation Vpol de manière à moduler les caractéristiques d'oscillation du résonateur.

Comme illustré à la figure 2, il est également possible en variante de remplacer la résistance 9 de polarisation par un troisième transistor 11 qui est connecté entre la borne d'excitation E et la tension d'alimentation Vdd. Dans ce cas, le potentiel de commande Vbias appliqué sur la borne de commande du troisième transistor permet d'ajuster le courant de polarisation. Le potentiel prédéterminé Vs appliqué sur l'électrode de commande du troisième transistor 11 permet de fixer le régime de fonctionnement du transistor. Le potentiel de commande Vbias peut être égal à celui de la borne d'excitation E, l'électrode de commande étant alors connectée à la borne d'excitation. Il est également envisageable d'utiliser une source d'alimentation extérieure pour fixer le potentiel de commande Vbias.

Dans une autre variante de réalisation, le premier transistor 6 est polarisé au moyen d'une résistance additionnelle 10 qui est connectée entre la borne de détection D et l'électrode de commande du premier transistor 6. Il est également possible, dans un mode de réalisation particulier illustré à la figure 2 et qui peut être combiné avec les autres modes de réalisation décrits, de réaliser cette résistance additionnelle au moyen d'un quatrième transistor 12. Le potentiel prédéterminé Vw qui est appliqué sur l'électrode de commande du quatrième transistor 12 est un potentiel constant. Ce second potentiel prédéterminé Vw est avantageusement égal à celui de l'élément fixe 8 additionnel ou alors un potentiel provenant d'une source extérieure.

Dans encore un autre mode de réalisation, il est également possible de réaliser un oscillateur qui est constitué par un résonateur 1 excité par des moyens capacitif et dont la détection du mouvement est réalisée par des moyens piézo-résistifs, par exemple dans un mouvement hors-plan.

Dans ce mode de réalisation, l'électrode d'excitation est avantageusement disposée sous l'élément mobile 3, typiquement une poutre encastrée double (encastrée/encastrée). Une jauge piézo-résistive est disposée sur la poutre et quand cette dernière se déforme, la jauge voit sa résistance évoluer. Ainsi, il est possible, par la mesure de la résistance de la jauge de détecter le mouvement de la poutre.

Comme dans les modes de réalisation précédents, la transconductance des transistors 6 et 7 de la boucle de réaction doit tenir compte des gains des moyens de détection de type piézorésistif et des gains des moyens d'excitation. La transconductance doit également tenir compte des bruits de phases associés au résonateur, au premier transistor 6, éventuellement au second transistor 7, et à la jauge piézo-résistive.

Dans un autre mode de réalisation, il est également envisageable de réaliser un oscillateur qui comporte un résonateur 1 à actionnement capacitif et détection piézoresistive. Ce résonateur peut avoir, par exemple, un mouvement dans le plan. Le bras de levier du résonateur 1 est actionné par une force électrostatique et son mouvement d'oscillation induit des contraintes en compression/dilatation dans les jauges placées perpendiculairement à ce bras de levier.

Dans une variante de réalisation du mode précédent, le résonateur 1 est constitué par un nanofil. L'excitation est réalisée par des moyens capacitifs et la détection est réalisée par des moyens piézorésistifs. En effet, les nanofils présentent un effet piézorésistif très important ce qui permet d'obtenir un gain de transduction très élevé des moyens de détection. Ce mode de réalisation est particulièrement avantageux car le gain électronique que doit fournir la boucle de réaction est d'autant plus faible. Le résonateur peut être obtenu en utilisant le nanofil comme résistance variable reliée au premier transistor 6, la variation de résistance étant induite par la déformation du nanofil.

Dans encore un autre mode de réalisation, les moyens d'excitation sont de type thermique alors que les moyens de détection sont de type piézorésistif.

Une telle mise en oeuvre a été proposée par Bargatin et al. « Efficient electrothermal actuation of multple mode of high-frequency nanomechanical resonators », Applied Physics Letters 90, 2007. Si les moyens de détection sont de type piézorésistifs, le résonateur peut être assimilé à une résistance variable.

Dans les cas où la détection est de type piézoélectrique, le résonateur peut être assimilé à une charge variable.

La topologie de l'oscillateur est de type Colpitts, le premier 6 ou les premier 6 et second 7 transistors sont polarisés par l'intermédiaire de l'élément de polarisation 2 capacitif. L'élément de polarisation 2 agit alors comme un amplificateur transimpédance qui est utilisé pour convertir le courant dynamique issu du résonateur 1 en une tension appropriée sur la borne d'excitation E.

Une tension d'amplification Vcas est appliquée sur l'électrode de commande du second transistor 7 de manière à pouvoir ajuster le courant émis à sa sortie et donc la polarisation appliquée sur la borne d'excitation E.

Cette architecture constitue un composant actif hybride résonateur/premier transistor co-intégré et dédié à la fonction d'oscillateur. Les différents éléments de l'oscillateur sont alors polarisés pour fixer le gain du premier transistor 6 à effet de champ et le déphasage du signal.

Ce circuit est particulièrement avantageux car la réduction des dimensions du résonateur 1 permet d'obtenir un élément mobile qui est situé à proximité immédiate des éléments fixes de détection et d'excitation. Il en résulte alors que grâce à cette réduction des dimensions, les gains des dispositifs de transduction sont fortement augmentés, particulièrement avec l'utilisation d'un nanofil. De ce fait, la boucle de réaction doit présenter un gain propre qui est typiquement celui d'un transistor ou de deux transistors en série.

La fréquence d'oscillation du dispositif résonant peut être ajustée de deux façons. La première méthode est avantageusement utilisée pour une utilisation du dispositif dans des applications à base de temps, typiquement la formation d'une fréquence de référence dans une application radiofréquence, par exemple une fréquence porteuse. Cette première méthode consiste à appliquer en plus du signal électrique émis par la boucle de réaction une polarisation Vpol sur la partie mécanique du résonateur.

Cette polarisation induit une contrainte électrostatique dans le résonateur. Cette contrainte électrostatique modifie les propriétés mécaniques du résonateur et donc sa fréquence d'oscillation. Cette méthode peut être appliquée sur un seul résonateur, sur plusieurs oscillateurs prédéfinis ou sur tous les oscillateurs avec des polarisations différentes entre eux. En cumulant tout ou partie des différents ajustements de fréquence des oscillateurs, il est possible d'ajuster aisément la fréquence d'oscillation globale du dispositif résonant. On a alors accès à une plage d'ajustement qui est beaucoup plus importante que pour un simple oscillateur.

Le seconde méthode consiste à ajuster le gain des boucles de réaction d'une ou plusieurs boucles de réaction. Comme dans la méthode précédente, cela se traduit, au final, par un ajustement aisé de la fréquence d'oscillation globale du dispositif résonant. Par exemple, l'ajustement du gain peut être réalisé en ajustant la tension de polarisation Vg, typiquement appliquée par l'intermédiaire de la résistance additionnelle 10. Cette méthode, totalement électrique, est simple à mettre en oeuvre, mais elle nécessite un adressage de chaque oscillateur.

Dans le mode de réalisation particulier où le dispositif résonant est utilisé en tant que capteur de masse, toute masse se plaçant sur un des oscillateurs électromécaniques va induire une modification de la fréquence globale du signal de sortie. L'influence du bruit étant réduite au moyen de l'utilisation d'une pluralité d'oscillateurs, le dispositif présente alors une résolution nettement améliorée par rapport aux dispositifs connus dans l'art antérieur.

Avantageusement, pour la réalisation d'un capteur de masse, le résonateur et donc l'oscillateur est de taille nanométrique voire micrométrique.

De plus, de part sa simplicité de mise en oeuvre, le dispositif résonant peut être facilement réalisé au sein d'un circuit intégré tout en conservant une taille compatible avec celle du circuit intégré.

Le dispositif résonant peut être couplé à un circuit de compensation de la température via les tensions de polarisation Vpol et Vg car la fréquence de résonance est une caractéristique qui dépend de la température.

## Revendications

1. Dispositif résonant **caractérisé en ce qu'**il comporte une pluralité d'oscillateurs synchronisés, chaque oscillateur comportant un résonateur électromécanique comportant des moyens de détection fournissant des signaux de détection, représentatifs de l'oscillation du résonateur (1), à une boucle de réaction connectée à une entrée d'excitation (E) du résonateur (1), les signaux de détection commandant la conductivité de ladite boucle de réaction de l'oscillateur, les entrées d'excitation (E) de tous les résonateurs (1) étant connectées à un point commun, constituant la sortie du dispositif résonant, une charge capacitive (5) étant connecté entre ledit point commun et une tension de référence (GND).

2. Dispositif selon la revendication 1, **caractérisé en ce que** le résonateur est un résonateur à quartz.

3. Dispositif selon la revendication 1, **caractérisé en ce que** le résonateur est de type à capacité variable, à résistance variable ou à charge variable.

4. Dispositif selon l'une des revendications 1 et 3, **caractérisé en ce que** le résonateur est de taille nanométrique ou micrométrique.

5. Dispositif selon l'une quelconque des revendications 1 à 4, **caractérisé en ce que** chaque boucle de réaction est constituée par un premier transistor (6) ou par des premier (6) et second (7) transistors connectés en série entre une tension de référence (GND) et l'entrée d'excitation (E).

6. Dispositif selon la revendication 5, **caractérisé en ce que** sur chaque électrode de commande du premier transistor (6) est appliqué un potentiel (Vg) correspondant.

7. Dispositif selon l'une quelconques des revendications 1 à 6, **caractérisé en ce qu'**une résistance de polarisation (9) est connectée entre l'entrée d'excitation (E) et une tension d'alimentation (Vdd).

8. Dispositif selon l'une quelconques des revendications 1 à 7, **caractérisé en ce qu'**un troisième transistor (11) est connecté entre l'entrée d'excitation (E) et une tension d'alimentation (Vdd).

**Claims**

1. A resonant device **characterized in that** it comprises a plurality of synchronized oscillators, each oscillator comprising an electromechanical resonator comprising detection means providing detection signals representative of oscillation of the resonator (1) to a feedback loop connected to an excitation input (E) of the resonator (1), the detection signals controlling the conductivity of said feedback loop of the oscillator, the excitation inputs (E) of all the resonators (1) being connected to a common point constituting the output of the resonant device, a capacitive load (5) being connected between said common point and a reference voltage (GND).

2. Device according to claim 1, **characterized in that** the resonator is a quartz resonator.

3. Device according to claim 1, **characterized in that** the resonator is of variable capacitance, variable resistance or variable load type.

4. Device according to one of claims 1 and 3, **characterized in that** the resonator is of nanometric or micrometric size.

5. Device according to any one of claims 1 to 4, **characterized in that** each feedback loop is formed by a first transistor (6) or by a first transistor (6) and second transistor (7) connected in series between a reference voltage (GND) and the excitation input (E).

6. Device according to claim 5, **characterized in that** a corresponding voltage (Vg) is applied on each control electrode of the first transistor (6).

7. Device according to any one of claims 1 to 6, **characterized in that** a bias resistor (9) is connected between the excitation input (E) and a supply voltage (Vdd).

8. Device according to any one of claims 1 to 7, **characterized in that** a third transistor (11) is connected between the excitation input (E) and a supply voltage (Vdd).

**Patentansprüche**

1. Resonanzvorrichtung, **dadurch gekennzeichnet, dass** sie eine Vielzahl von synchronisierten Oszillatoren umfasst, wobei jeder Oszillator einen elektromechanischen Resonator umfasst, welcher Erfassungsmittel aufweist, die Erfassungssignale, welche für die Schwingung des Resonators (1) repräsentativ sind, an eine an einen Erregungseingang (E) des Resonators (1) angeschlossene Rückkopplungsschleife liefern, wobei die Erfassungssignale die Leitfähigkeit der Rückkopplungsschleife des Oszillators steuern, wobei die Erregungseingänge (E) aller Resonatoren (1) an eine gemeinsame Stelle, die den Ausgang der Resonanzvorrichtung bildet, angeschlossen sind, wobei eine kapazitive Last (5) zwischen der gemeinsamen Stelle und einer Referenzspannung (GND) angeschlossen ist.

2. Vorrichtung nach Anspruch 1, **dadurch gekennzeichnet, dass** der Resonator ein Quarzresonator ist.

3. Vorrichtung nach Anspruch 1, **dadurch gekennzeichnet, dass** der Resonator vom Typ mit variabler Kapazität, mit variablem Widerstand oder mit variabler Last ist.

4. Vorrichtung nach einem der Ansprüche 1 und 3, **dadurch gekennzeichnet, dass** der Resonator von nanometrischer oder mikrometrischer Größe ist.

5. Vorrichtung nach einem der Ansprüche 1 bis 4, **dadurch gekennzeichnet, dass** jede Rückkopplungsschleife von einem ersten Transistor (6) oder von einem ersten (6) und einem zweiten (7) Transistor, die zwischen einer Referenzspannung (GND) und dem Erregungseingang (E) in Reihe geschaltet sind, gebildet ist.

6. Vorrichtung nach Anspruch 5, **dadurch gekennzeichnet, dass** an jede Steuerelektrode des ersten Transistors (6) ein entsprechendes Potential (Vg) angelegt ist.

7. Vorrichtung nach einem der Ansprüche 1 bis 6, **dadurch gekennzeichnet, dass** ein Polarisationswiderstand (9) zwischen dem Erregungseingang (E) und einer Speisespannung (Vdd) angeschlossen ist.

8. Vorrichtung nach einem der Ansprüche 1 bis 7, **dadurch gekennzeichnet, dass** ein dritter Transistor (11) zwischen dem Erregungseingang (E) und einer Speisespannung (Vdd) angeschlossen ist.

Figure 1

Figure 2

## RÉFÉRENCES CITÉES DANS LA DESCRIPTION

**Documents brevets cités dans la description**

- FR 2533777
- WO 2007135064 A

**Littérature non-brevet citée dans la description**

- **Feng et al.** A self-sustaining ultrahigh-frequency nanoelectromechanical oscillator. *nature nanotechnology,* Juin 2008, vol. 3
- **Colinet et al.** Measurement of Nano-Displacement Based on In-Plane Suspended-Gate MOSFET Detection Compatible with a Front-End CMOS Process. *ISSCC 2008,* 2008, 18.2
- **Bargatin et al.** Efficient electrothermal actuation of multple mode of high-frequency nanomechanical resonators. *Applied Physics Letters,* 2007, 90